# DEMANDE DE BREVET EUROPEEN

(11) **EP 4 739 051 A1**
(43) Date de publication de la demande: **06.05.2026**
(21) Numéro de dépôt: 25212692.5
(22) Date de dépôt: 31.10.2025
(51) Int. Cl.: H10K 59/12, H10K 59/35, H10K 59/122

(54) **DISPOSITIF D`AFFICHAGE ÉLECTROLUMINESCENT, PROCÉDÉ DE FABRICATION D'UN TEL DISPOSITIF ET SYSTÈME D`AFFICHAGE ÉLECTROLUMINESCENT**

(30) Priorité: 04.11.2024 FR 2412040
(71) Demandeur: Commissariat à l'Energie Atomique et aux Energies Alternatives, 75015 Paris (FR); Microoled, 38000 Grenoble Cedex 9 (FR)
(72) Inventeur: BALLOT, Clément, 38054 GRENOBLE CEDEX 09 (FR); GASSE, Adrien, 38054 GRENOBLE CEDEX 09 (FR); HAAS, Gunther, 38000 GRENOBLE CEDEX 09 (FR)
(74) Mandataire: Lebkiri, Alexandre

(57) **Abrégé**

Un aspect de l'invention concerne un procédé de fabrication d'un dispositif d'affichage électroluminescent à partir d'îlots séparés par une tranchée, le procédé comprenant :
- un remplissage de la tranchée avec un élément structurel isolant ;
- une formation d'un ruban protecteur (108) recouvrant, en partie seulement, chacun des îlots et chevauchant l'élément structurel ;
- une gravure partielle de l'élément structurel de manière à former un pilier (109) sous le ruban protecteur de sorte que ce dernier présente des parties (110a, 110b) en porte-à-faux ; et
- un dépôt d'une couche organique d'où il résulte deux portions distinctes et séparées, une première portion s'étendant de manière continue sur chaque îlot et sur le ruban protecteur, et une deuxième portion s'étendant sur le substrat.

## Description

### DOMAINE TECHNIQUE DE L'INVENTION

Le domaine technique de l'invention est celui des dispositifs optoélectroniques et plus particulièrement celui des dispositifs d'affichage matriciel à couches électroluminescentes organiques.

La présente invention concerne un procédé un dispositif d'affichage électroluminescent de type OLED (pour « Organic Light-Emitting Diodes » en anglais) ainsi qu'un procédé de fabrication d'un tel dispositif.

La présente invention trouve une application avantageuse pour la réalisation d'écrans d'affichage d'objets électroniques, et en particulier pour la réalisation d'écrans d'affichage couleur à haute résolution tels que des écrans d'affichage de type AMOLED (pour « Active Matrix Organic Light-Emitting Diodes » en anglais). L'expression « haute résolution » désigne des pixels de taille inférieure à 15 µm.

### ARRIÈRE-PLAN TECHNOLOGIQUE DE L'INVENTION

Dans le domaine des dispositifs d'affichage matriciel à couches électroluminescentes organiques, on connaît les micro- afficheurs (dit « microdisplay » en anglais) matriciels de type OLED qui présentent des pixels agencés selon un pas inférieur à 20 µm, typiquement entre 4 µm et 12 µm.

Lorsque ce type d'afficheur matriciel est en couleur, chaque pixel est subdivisé en sous-pixels de différentes couleurs (typiquement, trois, ayant pour couleur le rouge, le vert et le bleu) qui coopèrent pour que le pixel émette la couleur souhaitée. La surface des sous pixels peut être rectangulaire, carré, ou autre (par exemple octogonale) et leur taille peut dépendre de la couleur. La dimension typique des sous-pixels peut varier de 1 µm à 20 µm.

Chaque sous-pixel est généralement formé par plusieurs couches superposées, dont une électrode inférieure (l'anode) déposée sur un substrat commun, plusieurs couches organiques (dont une au moins est émissive) formant un empilement OLED sur chaque électrode inférieure, et une électrode supérieure (la cathode).

Les documents FR3079909A1 et US2023/0041252A1 décrivent des structures permettant de former des pixels OLED (ou sous-pixels OLED) d'aussi petite taille avec une fiabilité industrielle améliorée.

Ces structures ont comme avantage commun de permettre une discrétisation douce de l'empilement OLED et de la cathode pour former les pixels (ou sous-pixels). L'expression « discrétisation douce » désigne un procédé de structuration qui préserve les performances de l'empilement OLED.

En particulier, les solutions proposées consistent à réaliser la discrétisation de l'empilement OLED autrement qu'avec des étapes de masquage et de retrait qui, généralement, nécessitent des environnements (humidité, température supérieure à 90°C, solvants, ultra-violets, etc.) délétères pour les matériaux organiques.

Le document FR3079909 A1 décrit ainsi un premier dispositif d'affichage OLED dans lequel les électrodes inférieures de chaque sous-pixel sont séparées les unes des autres par un mur isolant s'élevant à la verticale du substrat. Chaque mur agit comme un séparateur entre deux sous-pixels voisins.

Ce même document FR3079909 décrit un deuxième dispositif dans lequel les murs isolants sont remplacés par des tranchées dans lesquelles une couche isolante est déposée.

Les murs isolants et les tranchées sont formés avant que l'empilement OLED soit déposé par évaporation thermique et jouent le même rôle. Comme la technique de dépôt par évaporation est majoritairement directive, l'empilement OLED est préférentiellement déposé sur les parois horizontales du dispositif, et non sur les parois latérales des murs isolants ou des tranchées. L'empilement OLED est ainsi rompu (ou discrétisé) au niveau des murs isolants ou des tranchées.

La directivité du dépôt de l'empilement OLED n'est toutefois en pratique jamais totale. Des particules organiques peuvent ainsi être aussi déposées sur les parois latérales des murs isolants ou des tranchées. Or, ces particules sont indésirables car elles dégradent l'isolation (électrique, optique) entre les sous-pixels. Des sous-pixels voisins peuvent alors interagir entre eux, par exemple par couplage capacitif ou par des courants parasites. Ces phénomènes, connus sous le nom de diaphonie ou « cross-talk » en anglais, conduisent à une dégradation des performances du dispositif d'affichage. Ces phénomènes sont exacerbés lorsque les sous-pixels sont des diodes électroluminescentes organiques dites « tandem », c'est-à-dire lorsque les sous-pixels comprennent plusieurs empilements OLED empilés et connectés en série grâce à des couches d'interconnexion.

Le document US2023/0041252A1 offre une solution à ce problème en décrivant des séparateurs de sous-pixels qui sont disposés sur un substrat et présentent une structure en forme de champignon (ou « hang-over » selon la terminologie anglaise utilisée dans ce document). Plus précisément, cette structure en champignon comprend une partie inférieure ayant des pans obliques, formant le pied du champignon. Elle comprend également une partie supérieure, de largeur supérieure à celle de la partie inférieure, qui masque une région du substrat. Cette partie supérieure forme le chapeau du champignon.

Les sous-pixels sont formés une fois les structures en champignon en place. L'empilement OLED est alors déposé sur ces structures et rompu au niveau des parties supérieures. La rupture de l'empilement OLED est réalisée avec une fiabilité satisfaisante puisque le matériau organique ne peut être déposé sur la région du substrat masquée par la partie supérieure ni sur les parois latérales de la structure en champignon (la partie inférieure n'est pas accessible depuis le haut car cachée par la partie supérieure). Ainsi, le degré de directivité du dépôt de l'empilement OLED importe peu.

Ces structures en champignon sont toutefois particulièrement complexes à réaliser et peu compactes (verticalement, elles présentent une hauteur de l'ordre de 1 µm). De plus, la réalisation d'une électrode supérieure (cathode) commune impose d'utiliser un équipement spécifique permettant de réaliser un dépôt orienté avec l'angle souhaité. Il s'agit en effet de réaliser un dépôt d'une couche conductrice sous la partie supérieure des structures en champignon, selon un angle bien particulier déterminé par l'inclinaison des pans des parties inférieures. Il n'est donc pas aisé, ni économiquement avantageux, de déployer un tel procédé de fabrication.

Il existe donc toujours un besoin d'un procédé de fabrication de dispositif d'affichage de type OLED à résolution améliorée qui soit moins coûteux et plus simple à mettre en œuvre.

### RÉSUMÉ DE L'INVENTION

L'invention offre une solution aux problèmes évoqués précédemment, en permettant de former une électrode supérieure commune entre plusieurs pixels (l'électrode supérieure étant généralement la cathode commune) en utilisant des structures de séparation intégrées aux électrodes inférieures des pixels (celles-ci étant souvent les anodes de ces pixels). Pour cela, l'invention permet de discrétiser les parties inférieures de deux pixels adjacents en offrant une surface continue entre ces deux pixels pour former une couche en matériau organique et une électrode supérieure continue.

Un aspect de l'invention concerne un procédé de fabrication d'un dispositif d'affichage électroluminescent à partir d'un précurseur, ledit précurseur comprenant une pluralité d'îlots, disposés sur un substrat, chaque îlot comprenant une couche support s'étendant sur le substrat ; et une couche conductrice s'étendant sur la couche support, les îlots étant séparés deux à deux par une tranchée, le procédé comprenant :
- un remplissage de chaque tranchée séparant les îlots avec un élément structurel isolant électriquement les îlots, pour chaque tranchée, le remplissage étant réalisé jusqu'à ce que ledit élément structurel atteigne le sommet des îlots séparés par ladite tranchée ;
- une formation d'au moins un ruban protecteur, chaque ruban protecteur connectant deux îlots entre eux en chevauchant la tranchée séparant lesdits deux îlots et en recouvrant l'élément structurel s'étendant dans la tranchée, chaque ruban protecteur recouvrant, en partie seulement, chacun des deux îlots qu'il connecte ;
- une gravure partielle de l'élément structurel de manière sélective par rapport à chaque ruban protecteur et par rapport aux couches conductrices des îlots, la gravure partielle comprenant au moins une phase de gravure isotrope, la gravure partielle étant réalisée de manière à ne conserver qu'une portion de l'élément structurel disposée sous chaque ruban protecteur et ladite portion formant un pilier pour chaque ruban protecteur, la gravure partielle étant en outre réalisée de sorte qu'au moins une partie de chaque ruban protecteur s'étendant en porte-à-faux au-delà du pilier qui le supporte ; et
- un dépôt d'une couche organique de manière anisotrope avec un angle sensiblement perpendiculaire au substrat d'où il résulte deux portions distinctes et séparées de la couche organique dont, une première portion s'étendant de manière continue sur chaque îlot et sur chaque ruban protecteur, et une deuxième portion s'étendant sur le substrat, une épaisseur de dépôt de la couche organique étant choisi de sorte que la deuxième portion de la couche organique n'atteigne pas ladite au moins une partie en porte-à-faux de chaque ruban protecteur.

Chaque îlot comprend une couche conductrice pouvant former une électrode inférieure. L'utilisation d'une couche support pour chaque îlot permet de surélever cette couche conductrice par rapport au substrat. Le ruban protecteur s'étend d'un îlot à l'autre et est supporté par l'élément isolant. Chaque ruban protecteur forme un pont entre deux îlots. Ce pont permet de former une couche organique de manière continue sur les îlots et sans coupure entre les îlots. Une couche conductrice supplémentaire peut alors être déposée sur cette couche organique de manière à former une électrode supérieure continue et sans coupure entre les îlots. Elle permet de former une électrode supérieure commune (par exemple une cathode commune) à tous les îlots.

Le retrait d'une partie de l'élément structurel sous chaque ruban protecteur permet alors de former un pont présentant des parties en porte-à-faux surplombant le substrat dans la tranchée. Par « partie en porte-à-faux », on entend une partie suspendue ou sans support. Il y a donc une discontinuité entre le bord du pont et le substrat. Dès lors, le dépôt d'un matériau organique sur les îlots et les ponts permet d'obtenir deux portions distinctes dudit matériau organique, sans contact électrique entre elles. Lors du dépôt, une portion du matériau organique se dépose sur chaque ruban protecteur et notamment sur les parties en porte-à-faux de chaque ruban protecteur, tandis qu'une autre portion tombe entre les îlots, sur le substrat. La présence des parties en porte-à-faux brise la continuité entre les rubans protecteurs et le substrat. Tant que l'épaisseur du matériau organique déposé ne permet pas à la portion s'étendant sur le substrat d'atteindre les parties en porte-à-faux, les deux portions du matériau organique (celle sur les ponts et les îlots, et celle sur le substrat) restent distinctes et sans continuité physique et électrique.

Ainsi, il est possible de former une couche organique et une électrode commune à plusieurs îlots, sans risque de court-circuit avec les électrodes inférieures et sans risque de contact électrique avec des éléments environnants (tels qu'un îlot supplémentaire non destiné à être connecté à ces îlots). Cela permet ainsi de réaliser un dispositif d'affichage de meilleure facture et également de simplifier sa fabrication. En effet, un dépôt pleine plaque, même imparfaitement directif, peut être utilisé pour former les éléments actifs et les électrodes supérieures des pixels finaux.

De plus, lorsque le dispositif comprend plus de deux îlots, séparés les uns des autres par des tranchées, il est alors possible de connecter les îlots deux à deux avec un pont tel que proposé précédemment, pour former une couche organique commune et/ou une cathode commune. Il n'est pas nécessaire de prévoir des éléments de séparation supplémentaires pour s'assurer de l'isolation électriques entre les pixels finaux. Il est alors possible de former des chaînes distinctes de pixels, chaque chaîne ayant une cathode commune. Cela réduit, par rapport aux solutions de l'art antérieur, le nombre d'étapes à mettre en œuvre. Le procédé de fabrication est ainsi plus simple et plus rapide à mettre en œuvre.

Avantageusement, la gravure partielle de l'élément structurel est réalisée de sorte que l'écart latéral de ladite au moins une partie en porte-à-faux de chaque ruban protecteur par rapport au pilier qui le supporte est strictement supérieure à 100 nm.

Avantageusement, pour chaque tranchée, le remplissage est réalisé jusqu'à que l'élément structurel dépasse les couches conductrices des deux îlots séparés par ladite tranchée d'une hauteur comprise entre 10 nm et 100 nm.

Avantageusement, chaque îlot comprend, avant le remplissage de chaque tranchée, une couche sacrificielle s'étendant sur la couche conductrice, le remplissage de chaque tranchée avec l'élément structurel étant réalisé de sorte que l'élément structurel atteigne le sommet des couches sacrificielles s'étendant sur les îlots.

Avantageusement, le procédé comprend en outre, après le remplissage de chaque tranchée et avant la formation de chaque ruban protecteur, une gravure de la couche sacrificielle de chaque îlot de manière sélective par rapport à l'élément structurel, la gravure étant réalisée avec arrêt sur ladite couche conductrice dudit ilot.

Avantageusement, pour chaque tranchée, le remplissage avec l'élément structurel comprend :
- un dépôt d'une couche en matériau électriquement isolant de manière à remplir complètement ladite tranchée ;
- un polissage de la couche en matériau électriquement isolant avec un arrêt sur la couche sacrificielle de chaque îlot.

Avantageusement, pour chaque tranchée, le remplissage avec l'élément structurel comprend les étapes suivantes :
- un dépôt d'une couche diélectrique de manière conforme dans ladite tranchée ;
- un dépôt d'une couche en matériau de remplissage sur la couche diélectrique de manière à remplir complètement ladite tranchée ;
- un polissage de la couche diélectrique et la couche de remplissage avec un arrêt sur la couche sacrificielle de chaque îlot.

Avantageusement, le matériau de remplissage est du silicium amorphe ou du silicium polycristallin.

Avantageusement, le procédé comprend, avant la formation de chaque ruban protecteur, un fluage ou un gonflement de l'élément structurel de sorte qu'il déborde sur une portion de la couche conductrice de chaque îlot en formant au moins une surface libre continue et sans arête, s'étendant de la couche conductrice d'un des îlots à la couche conductrice d'un autre îlot, chaque surface libre présentant une pente, mesurée par rapport au substrat, comprise entre -45 degrés et 45 degrés et préférentiellement entre -20 degrés et +20 degrés.

Avantageusement, chaque ruban protecteur est électriquement isolant.

Avantageusement, la gravure partielle de l'élément structurel comprend au moins une phase de gravure anisotrope et au moins une phase de gravure isotrope, par exemple en alternance, chaque phase de gravure anisotrope étant réalisée avec une directivité sensiblement perpendiculaire au substrat.

Avantageusement, le procédé comprend, après le dépôt de la couche organique, un dépôt d'une couche conductrice supplémentaire de manière anisotrope d'où il résulte deux portions distinctes et séparées de la couche conductrice supplémentaire dont, une première portion de la couche conductrice supplémentaire s'étendant de manière continue sur la première portion de la couche en matériau organique, et une deuxième portion de la couche conductrice supplémentaire s'étendant sur la deuxième portion de la couche organique, une épaisseur de dépôt de la couche conductrice supplémentaire étant choisi de sorte que la deuxième portion de la couche conductrice supplémentaire n'atteigne pas ladite au moins une partie en porte-à-faux de chaque ruban protecteur.

Avantageusement, la gravure partielle de l'élément structurel est en outre réalisée de manière à graver partiellement la couche support de chaque îlot de sorte que, pour chaque îlot, au moins une partie de la couche conductrice dudit îlot s'étende en porte-à-faux au-delà de la couche support dudit îlot.

Un autre aspect de l'invention concerne un dispositif d'affichage électroluminescent comprenant une pluralité d'îlots, disposés sur un substrat, chaque îlot comprenant une couche support s'étendant sur le substrat et une couche conductrice s'étendant sur la couche support, le dispositif comprenant :
- au moins une tranchée séparant les îlots deux à deux ;
- au moins un ruban protecteur, chaque ruban protecteur connectant deux îlots entre eux en chevauchant la tranchée séparant lesdits deux îlots et en recouvrant le pilier s'étendant dans la tranchée, chaque ruban protecteur recouvrant, en partie seulement, chacun des deux îlots ;
- au moins un pilier remplissant au moins en partie une tranchée et isolant électriquement les îlots séparés par ladite tranchée, chaque pilier atteignant ou dépassant le sommet des deux îlots séparés par ladite tranchée, chaque pilier étant disposé sous un ruban protecteur pour supporter ledit ruban protecteur de sorte qu'au moins une partie dudit ruban protecteur s'étendant en porte-à-faux au-delà dudit pilier ; et
- une couche organique présentant deux portions distinctes et séparées l'une de l'autre dont, une première portion s'étendant de manière continue sur chaque îlot et sur chaque ruban protecteur, et une deuxième portion s'étendant sur le substrat sans atteindre ladite au moins une partie en porte-à-faux de chaque ruban protecteur.

Avantageusement, l'écart latéral de ladite au moins une partie en porte-à-faux de chaque ruban protecteur par rapport au pilier qui le supporte est strictement supérieure à 100 nm.

Avantageusement, ledit moins un pilier est réalisé à partir d'un matériau électriquement isolant.

Avantageusement, ledit au moins un pilier comprend une couche diélectrique, permettant d'isoler électriquement les îlots séparés par ledit au moins un pilier ; et un matériau de remplissage, isolant ou non, offrant un support au ruban protecteur, la couche diélectrique dudit au moins un pilier sépare le matériau de remplissage dudit au moins un pilier de chaque îlot.

Avantageusement, ledit au moins un pilier présente une surface continue et sans arête sur laquelle s'étend le ruban protecteur, ladite surface continue et sans arrête s'étendant de la couche conductrice d'un des îlots à la couche conductrice d'un autre îlot, chaque continue et sans arrête présentant une pente, mesurée par rapport au substrat, comprise entre -45 degrés et 45 degrés et préférentiellement entre -20 degrés et +20 degrés.

L'invention concerne en outre un système d'affichage électroluminescent, comprenant :
- un dispositif selon l'invention ; et
- une matrice d'adressage active comprenant une pluralité de transistors, chaque transistor de la pluralité de transistors étant connecté à la couche conductrice d'un des îlots dudit dispositif.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
[Fig. 1], [Fig. 2] et [Fig. 3] montrent schématiquement, selon trois vues, un mode de réalisation d'un précurseur de dispositif d'affichage selon l'invention.
[Fig. 4], [Fig. 5] et [Fig. 6] montrent schématiquement, selon trois vues, une première étape d'un procédé de fabrication du dispositif d'affichage selon l'invention.
[Fig. 7], [Fig. 8] et [Fig. 9] montrent schématiquement, selon trois vues, une deuxième étape du procédé de fabrication du dispositif d'affichage selon l'invention.
[Fig. 10] et [Fig. 11] montrent schématiquement, selon deux vues, des exemples de rubans protecteurs selon l'invention.
[Fig. 12] et [Fig. 13] montrent schématiquement deux autres exemples de rubans protecteurs selon l'invention.
[Fig. 14], [Fig. 15], [Fig. 16] et [Fig. 17] montrent schématiquement, selon trois vues, une troisième étape du procédé de fabrication du dispositif d'affichage selon l'invention.
[Fig. 18], [Fig. 19] et [Fig. 20] montrent schématiquement, selon trois vues, une quatrième étape du procédé de fabrication du dispositif d'affichage selon l'invention.
[Fig. 21], [Fig. 22] et [Fig. 23] montrent schématiquement, selon trois vues, une cinquième étape du procédé de fabrication du dispositif d'affichage selon l'invention.
[Fig. 24], [Fig. 25], [Fig. 26], [Fig. 27] et [Fig. 28] montrent schématiquement quatre étapes d'une variante du procédé de fabrication selon l'invention.

### DESCRIPTION DÉTAILLÉE

La présente invention vise à améliorer la fabrication de dispositifs d'affichage électroluminescents organiques à résolution améliorée, aussi appelés micro-afficheurs OLED (pour « Organic Light-Emitting Diodes » en anglais).

Dans la description qui suit, le terme « pixel » désigne un sous-pixel, c'est-à-dire le plus petit élément composant un pixel d'un dispositif 200 d'affichage électroluminescent.

Les pixels ont de préférence des dimensions latérales inférieures à 20 µm, voire inférieures à 10 µm, de préférence comprises entre 5 µm et 1 µm, par exemple égales à 3 µm. Ils sont par exemple agencés avec un pas inférieur à 20 µm, par exemple compris entre 4 µm et 12 µm. En vue de dessus, ils ont par exemple une forme rectangulaire, avec rapport longueur:largeur d'environ 3:1. La taille des pixels désignera ci-après le côté du carré.

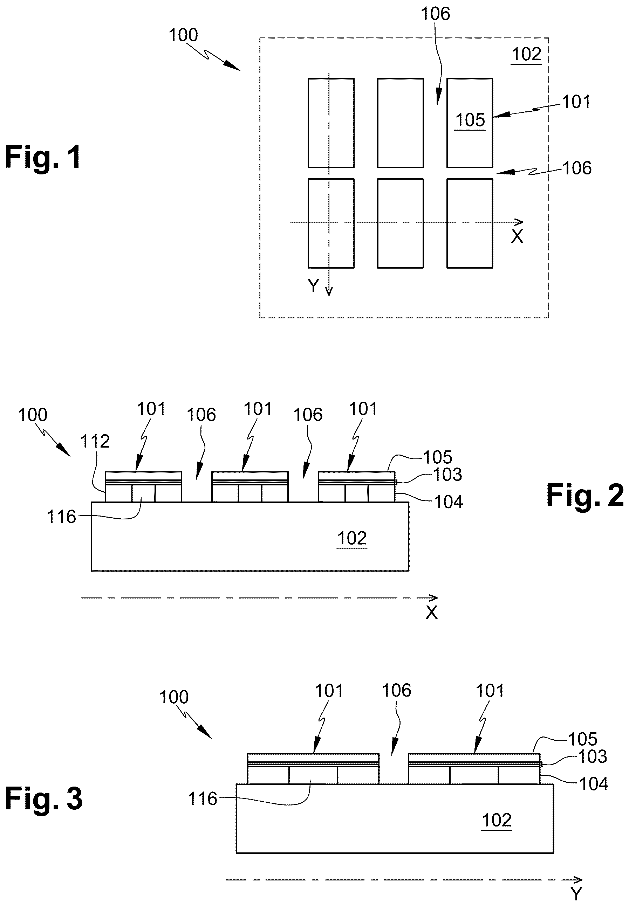

La présente invention concerne ainsi un procédé de fabrication d'un dispositif d'affichage électroluminescent à partir d'un précurseur 100. Un exemple de précurseur 100 est présenté en figures 1 à 3. Ces figures montrent notamment le précurseur 100 selon une vue de dessus (figure 1), et selon deux coupes (figures 2 et 3) correspondant aux directions X et Y montrées dans la figure 1.

Dans cet exemple, le précurseur comprend un substrat 102 et une pluralité d'îlots 101. Les îlots 101 sont destinés à former les pixels finaux du dispositif 200 d'affichage. Ils présentent, en vue de dessus, une forme rectangulaire. Alternativement, ils pourraient présenter une forme carrée, triangulaire, hexagonale, circulaire ou tout autre forme. Ils sont disposés sur le substrat 101 par groupe de deux, en l'occurrence trois groupes de deux îlots. Chaque groupe de deux îlots forme une colonne et est par exemple aligné parallèlement à la direction Y. Une section d'un des groupes de deux îlots 101 correspond à la section de la figure 3. Les trois colonnes (c'est-à-dire les trois groupes de deux îlots 101) sont réparties selon la direction orthogonale X. Les îlots 101 peuvent par exemple être également alignés selon la direction X pour former ainsi des lignes d'îlots 101. Les îlots 101 peuvent être agencés selon les directions X ou Y avec un pas inférieur à 20 µm, par exemple compris entre 4 µm et 12 µm. Ainsi, les groupes d'îlots peuvent alors également être agencés avec un pas inférieur à 20 µm, par exemple compris entre 4 µm et 12 µm. Alternativement, les îlots peuvent être agencés autrement. Par exemple, les îlots au sein d'un groupe peuvent être agencés selon un réseau hexagonal (dit aussi « réseau en nid d'abeille » ou « honeycomb lattice » en anglais). Le pas est alors adapté pour correspond à un agencement hexagonal avec un pas inférieur à 20 µm, par exemple compris entre 4 µm et 12 µm.

Le substrat 102 est avantageusement un circuit spécialisé ou ASIC (pour « Application Specific Integrated Circuit » en anglais) de type CMOS (pour « Complementary Metal Oxyde Semiconductor ». Dans ce cas, le substrat 102 est opaque et donc, avantageusement adapté pour fabriquer un dispositif d'affichage électroluminescent de type émission par le haut. Dans la suite de la description, les termes « transparent » et « opaque » se réfèrent à un élément qui, présente, pour au moins une longueur d'onde de la bande spectrale [400 nm ; 1000 nm], voire [400 nm ; 2000 nm], un coefficient de transmission optique respectivement supérieur à 60%, et inférieur ou égal à 60%.

Notons que le substrat 102 peut alternativement être réalisé avec du silicium amorphe, du silicium polycristallin et/ou déposés sur une plaque de verre. Dans ce dernier cas, le substrat 102 peut être transparent et donc adapté pour fabriquer un dispositif d'affichage électroluminescent de type « émission par le bas ».

Le substrat 102 comprend un circuit d'adressage (non représenté) configuré pour adresser les pixels finaux du dispositif 200 d'affichage. Le substrat 102 peut également comporter une couche électriquement isolante qui peut être un oxyde, un nitrure ou un oxynitrure. Cette couche isolante est par exemple formée à base de nitrure de silicium (SiN). Le substrat 102 peut en outre comporter une pluralité de plots de contact aménagés à travers la couche isolante afin de réaliser un contact électrique avec les pixels finaux du dispositif 200.

Tous les îlots 101 sont séparés les uns des autres par au moins des tranchées 106. Les tranchées 106 séparent les colonnes d'îlots 101 et les lignes d'îlots 101. Autrement dit, au sein d'un groupe d'îlots 101, les îlots 101 sont séparés par une tranchée 106. Chaque tranchée 106 est creusée du sommet des îlots 101 jusqu'au substrat 102. Les tranchées 106 peuvent séparer partiellement les îlots 101, en n'étant par exemple creusées que sur une partie de la hauteur des îlots (les îlots 101 partage par exemple une partie basse). Les tranchées 106 peuvent être également creusées dans le substrat 102, pour améliorer l'isolation des îlots 101. Les îlots 101 peuvent être agencés avec un pas inférieur à 20 µm, par exemple compris entre 4 µm et 12 µm. La largeur d'une tranchée 106 séparant deux îlots 101 adjacents est par exemple comprise entre 0,3 µm et 1,5 µm.

Les îlots 101 d'un même groupe (par exemple d'une même colonne) sont par exemple destinés à former des pixels qui émettront une même gamme de longueur d'onde. Les trois colonnes d'îlots 101 illustrées correspondent par exemple à différentes longueurs d'onde, telles que les longueurs correspondant respectivement au bleu, au vert et au rouge.

Chaque îlot 101 présente une forme de mésa. C'est-à-dire qu'il est délimité par un flanc 112 unique, s'étendant du substrat 101 jusqu'au sommet de l'îlot 101. Les flancs 112 des îlots forment d'ailleurs les bords des tranchées 106. En vue de dessus, les îlots 101 peuvent présenter une forme rectangulaire avec un rapport hauteur:largeur égal à 3:1 à 10% près. Les îlots 101 peuvent présenter des formes carrés, hexagonales, circulaires ou similaire. Chacun d'eux présente une surface, en vue de dessus (figure 1) avantageusement inférieure à 40 µm², de préférence comprise entre 30 µm² et 1 µm², par exemple égale à 5 µm².

Chaque îlot 101 comprend une couche support 104, s'étendant sur le substrat 102. Elle s'étend directement contre le substrat 102 ou peut être séparée de ce dernier par une autre couche (par exemple une barrière de diffusion ou une couche favorisant une croissante cristallographique particulière). La couche support 104 présente une épaisseur H104 pouvant être comprise entre 150 nm et 1000 nm. La couche support 104 peut être conductrice auquel cas elle peut être réalisée à partir d'aluminium AI, d'alliage cuivre-aluminium AlCu, de chrome Cr ou encore d'argent Ag. Alternativement, elle peut être électriquement isolante et dans ce cas-là réalisée à partir d'un diélectrique tel que l'oxyde de silicium SiO2, le nitrure de silicium SiN ou l'oxyde d'aluminium Al2O3.

Chaque îlot 101 comprend également une couche conductrice 103. La couche conductrice 103 est destinée à former une électrode du pixel final et en l'occurrence une électrode inférieure. Dans la suite de la description, la couche conductrice 103 pourra être nommée indifféremment « électrode inférieure ». L'électrode inférieure 103 s'étend sur la couche support 104. Elle s'étend directement contre la couche support 104 ou elle peut être séparée de cette dernier par une autre couche (telle qu'une barrière de diffusion ou une couche favorisant une croissante cristallographique particulière). L'électrode inférieure 103 est préférentiellement parallèle au substrat 102.

L'électrode inférieure 103 peut être réfléchissante par exemple pour un dispositif d'affichage électroluminescent de type « émission par le haut ». La couche support 104 est avantageusement réfléchissante ou opaque. En émission par le haut, tout ou partie de la couche support 104 peut d'ailleurs être conductrice. La couche support 104 comprend par exemple une portion isolante (entourant par exemple des moyens de contact avec un via situé en dessous de l'îlot). Elle peut également être conductrice. Le terme « réfléchissant » désigne une surface ou un élément qui présente, pour au moins une longueur d'onde de la bande spectrale [400 nm ; 1000 nm], voire [400 nm ; 2000 nm], un coefficient de réflexion optique supérieur à 60%. L'électrode inférieure 103 peut être transparente, pour un dispositif d'affichage électroluminescent de type « émission par le bas ». Dans ce cas, la couche support 104 est avantageusement transparente. Elle comprend par exemple une portion isolante (entourant par exemple des moyens de contact avec un via situé en dessous de l'îlot) en diélectrique transparent. La couche support 104 est toutefois avantageusement conductrice. Elle comprend par exemple un moyen de connecter l'ilots avec un via situé dans le substrat 102 (voir les piliers conducteurs 116 décrits plus bas). Elle peut également être entièrement conductrice.

L'électrode inférieure 103 peut alternativement comprendre plusieurs sous-couches empilées. Chaque sous-couche est alors formée d'un matériau métallique ou d'un alliage métallique différent. Le ou les matériaux métalliques (ou alliages métalliques) utilisé(s) pour former la première couche conductrice 103 présentent préférentiellement tous la propriété d'être résistants à la chimie de gravure de la couche support 104 et/ou de l'élément structurel 107.

Lorsque la couche support 104 est isolante et comprend par exemple un diélectrique tel que le SiO2, l'électrode inférieure 103 peut être formée à partir d'un matériau métallique ou d'un alliage conducteur. L'électrode inférieure 103 comprend par exemple un empilement de sous-couches conductrices tels que Ti/TiN/SnO₂. Dans ce cas, l'épaisseur de l'électrode inférieure 103 est de préférence supérieure à 20 nm, et de préférence comprise entre 40 nm et 100 nm. Alternativement, l'électrode inférieure 103 peut être formée à partir d'un oxyde transparent conducteur (ou TCO, pour « Transparent Conductive Oxyde » en anglais) pour réaliser un dispositif d'affichage électroluminescent de type « émission par le bas ».

Lorsque la couche support 104 est conductrice, l'électrode inférieure 103 est de préférence formée à partir d'un oxyde transparent conducteur, par exemple de l'oxyde d'indium-étain (ou ITO pour « Indium Tin Oxide » selon la terminologie anglosaxonne couramment utilisée), ou d'oxyde de zinc (ZnO) ou d'oxyde de zinc dopé aluminium (ou « AZO » pour « Aluminum Zinc Oxyde » en anglais) ou en oxyde d'étain SnO2.

Lorsque l'électrode inférieure 103 est un empilement de sous-couches conductrices, ces sous-couches peuvent être formée à partir de nitrure de titane TiN ou d'oxyde d'étain SnO2 ou de Poly(3,4-ethylenedioxythiophene) (ou PEDOT), ou d'ITO, ou d'oxyde de zinc (ZnO) ou d'AZO. Préférentiellement, la sous-couche destinée à être en contact avec une couche organique est en oxyde d'étain SnO2 tandis que la sous-couche en contact avec la couche support 104 est en nitrure de titane TiN.

L'électrode inférieure 103 présente préférentiellement une épaisseur comprise entre 4 nm et 20 nm. Lorsqu'elle comprend un empilement de sous-couches, les épaisseurs peuvent varier en fonction des matériaux. Par exemple, une sous-couche en TCO présente par exemple une épaisseur comprise entre 10 nm et 20 nm. Une sous- couche en TiN présente par exemple une épaisseur inférieure à 10 nm, de préférence comprise entre 4 nm et 8 nm

La couche support 104 est destinée à soutenir l'électrode inférieure 103. Dit autrement, la couche support 104 est un élément de liaison entre le substrat 102 et l'électrode inférieure 103, qui assure le maintien de l'électrode inférieure 103 sur le substrat 102. L'électrode inférieure 103 n'est donc pas en contact direct avec le substrat 102.

La couche support 104 est au moins en partie conductrice, de sorte qu'elle a aussi pour fonction de réaliser une connexion électrique entre l'électrode inférieure 103 et un plot de contact ou un via situé en dessous de l'îlot (et donc du pixel final). Pour chaque îlot 101, si la couche support 104 n'est pas conductrice, elle peut comprendre un pilier conducteur 116 (pour l'exemple, les piliers sont uniquement représentés dans les figures 2 et 3), en contact avec l'électrode inférieure 103, et entouré par un matériau diélectrique (tels que ceux cités précédemment). La présence du matériau diélectrique dans cette couche 104 permet de fournir ou améliorer le maintien de l'électrode inférieure 103, d'un point de vue mécanique.

Pour simplifier la description, dans la suite de la description, et sauf mention contraire, seulement deux îlots 101 voisins d'une même colonne sont considérés. Ils correspondent par exemple aux îlots des figures 3, 6, 9, 12, 13, 16, 19, 22, 24, 25, 26, 27 et 28. Autrement dit, on considère deux îlots 101 voisins, séparés par une même tranchée 106. Les enseignements décrits ci-après peuvent être transposés à une colonne de plus de deux îlots 101, il suffit de considérer les îlots 101 deux à deux.

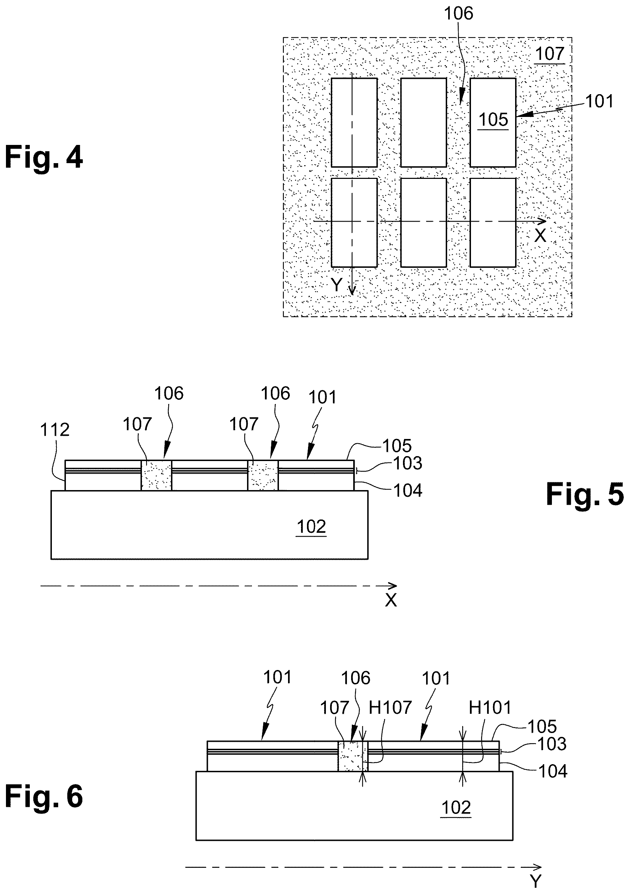

Les figures 4 à 9 montrent une étape de remplissage de la tranchée 106, séparant les deux îlots 101, au moyen d'un élément structurel 107. Cet élément structurel 107 sépare ainsi les deux îlots 101 tout en assurant une isolation électrique entre eux. L'élément structurel 107 remplit préférentiellement la totalité de la tranchée 106 et est en contact direct avec les deux îlots 101.

À la fin du remplissage, l'élément structurel 107 atteint le sommet des deux îlots 101. Autrement dit, l'élément structurel 107 présente une hauteur H107, mesurée perpendiculairement au substrat 102 et depuis ce substrat, supérieure ou égale, et préférentiellement égale, aux hauteurs H101 des îlots 101. La hauteur H101 est par exemple mesurée depuis le substrat 102 et jusqu'au sommet de chaque îlot 101.

Dans un mode de mise en œuvre, le remplissage de la tranchée 106 est réalisé jusqu'à atteindre les couches conductrices 103. Par « atteindre les couches conductrices », on entend que l'élément structurel 107 présente une hauteur, mesurée depuis le substrat 102, lui permettant d'être en contact direct avec les couches conductrices 103. Autrement dit, l'élément structurel 107 arase les couches conductrices 103 ou dépasse les couches conductrices 103. De préférence, l'élément structurel 107 arase les couches conductrices 103.

Dans une variante du procédé, détaillée ci-dessous, les îlots 101 peuvent comprendre des couches sacrificielles 105, augmentant la hauteur H101 totale de chaque îlot 101. En présence des couches sacrificielles 105, le remplissage de la tranchée 106 est réalisée jusqu'à atteindre le sommet des îlots 101, c'est-à-dire le sommet des couches sacrificielles 105. Dès lors, l'élément structurel 107 dépasse les couches conductrices 103.

Selon cette variance, la différence de hauteur entre l'élément structurel 107 et les couches conductrices 103, H73 = H107 - H103 est supérieure ou égale à zéro. Les couches conductrices 103 pourraient être non planes et présenter des hauteurs différentes. Dans ce cas-là, les hauteurs sont comparées à la verticale du flanc 112 des îlots 101 et en particulier, à la verticale de la portion en contact avec l'élément structurel 107.

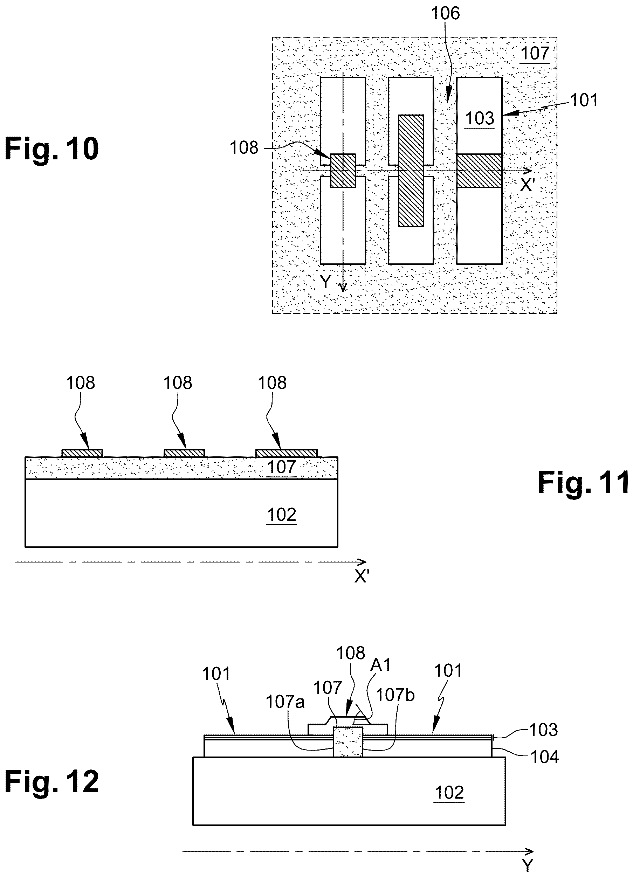

Les figures 10 à 13 illustrent un ruban protecteur 108. Le ruban protecteur 108 forme un pont entre les deux îlots 101 d'une même colonne. Il permet ainsi de supporter une couche en matériau organique s'étendant de manière continue et d'un seul tenant sur les deux îlots 101.

Le ruban protecteur 108 est donc une couche d'un seul tenant, c'est-à-dire continue, sans coupure ni cassure, s'étendant depuis l'un des îlots 101 jusqu'à l'autre îlot 101. Le ruban protecteur 108 recouvre une partie seulement de chaque îlot 101. De la sorte, la couche en matériau organique pourra être en contact direct avec le reste de chaque électrode inférieure 103.

Le ruban protecteur 108 s'étend également sur l'élément structurel 107 séparant les deux îlots de manière à en recouvrir au moins une partie. Dans la figure 10, trois exemples de ruban protecteur 108 sont illustrés. Selon un premier exemple, préféré, dans une première colonne (colonne de gauche), le ruban protecteur 108 s'étend sur une partie de l'électrode inférieure 103 d'un îlot 101 et se prolonge selon la direction Y jusqu'à l'autre îlot 101 de la colonne. Le masque 108 ne recouvre qu'une petite portion de chaque îlot 101 et une petite portion de l'élément structurel 107. Selon un deuxième exemple, dans une deuxième colonne (centrale), le ruban protecteur 108 s'étend sur une partie plus importante de chaque électrode inférieure 103, en traversant en partie les surfaces de ces électrodes. Selon un troisième exemple, dans une troisième colonne (à droite), le ruban protecteur 108 s'étend dans le prolongement des deux îlots 101 en recouvrant totalement l'élément structurel 107 qui sépare les deux îlots 101. La figure 11 montre une coupe de ces différents exemples.

Le ruban protecteur 108 permet de former un pont permettant de déposer des couches de matériaux continues sur deux îlots 101 voisins. Il peut être nécessaire de former une couche continue sur plus de deux îlots 101, par exemple pour connecter tous les îlots appartenant à une même colonne d'îlots 101. Dans ce cas, plusieurs rubans protecteur 108 peuvent être formés, chacun deux recouvrant deux îlots 101 voisins ainsi que l'élément structurel 107 qui les sépare.

Il peut être avantageux que chaque ruban protecteur 108 ne se limite qu'à deux îlots 101 voisins (ainsi que l'élément structurel 107 associé). Toutefois, pour former une couche continue sur plus de deux îlots 101, le ruban protecteur peut être formé de manière à recouvrir chacun de ces îlots 101 tout en conservant une couche continue, d'un seul tenant. Autrement, il peut être préférable que chaque ruban protecteur 108 ne se limite qu'à deux îlots 101 (et l'élément structurel 107 associé) et strictement ces deux îlots 101.

La figure 12 montre un exemple de ruban protecteur 108. Ce ruban 108 correspond par exemple à l'exemple de gauche de la figure 10. Le ruban protecteur 108 recouvre une partie de chaque électrode inférieure 103 tout en enjambant l'élément structurel 107 séparant ces îlots 101.

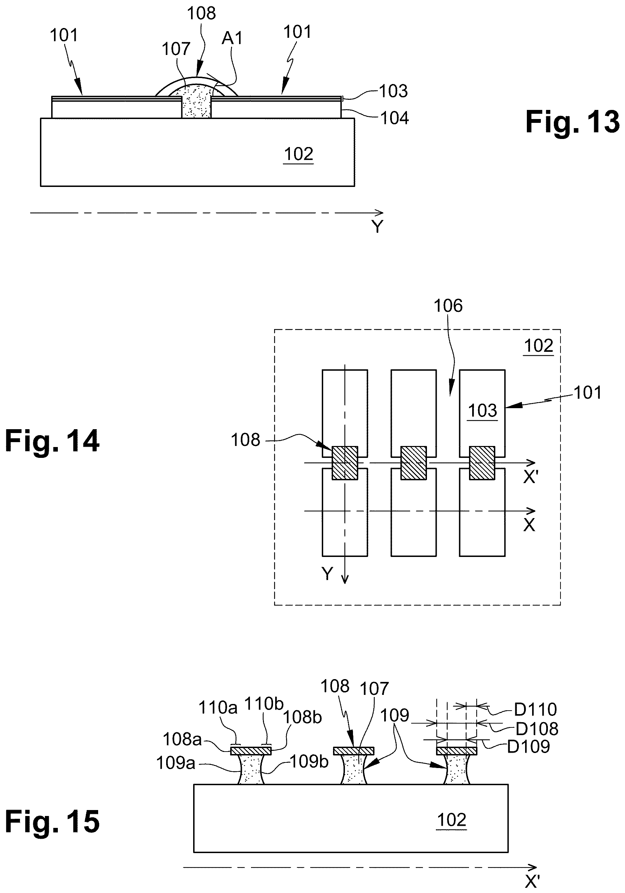

La figure 13 montre un autre exemple de ruban protecteur 108. Ce ruban 108 peut également correspondre à l'exemple de gauche de la figure 10. Dans cet exemple, l'élément structurel 107 déborde en partie sur chaque îlot 101. Il présente notamment une surface supérieure s'étendant d'une première électrode inférieure 103 à l'autre et formant une pente douce. Par « pente douce », on entend une pente, mesurée par rapport au substrat 102, comprise entre -45 degrés et 45 degrés et préférentiellement entre -20 degrés et +20 degrés et de manière encore préférée entre -5 degrés et +5 degrés. Le ruban protecteur 108 recouvre une partie de chaque électrode inférieure 103 et l'élément structurel 107 en montrant également une pente douce.

Le ruban protecteur 108 est préférentiellement électriquement isolant afin d'éviter un court-circuit entre les électrodes inférieures 103 des îlots 101 joints par ce ruban 108. Il est par exemple en oxyde d'aluminium Al₂O₃ ou SiO₂ ou SiN. Il est préférentiellement résistant aux chimies de gravure de l'éléments structurel 107.

Les figures 14 à 16 présentent l'issue d'une gravure partielle de l'élément structurel 107. La gravure est réalisée de manière sélective par rapport au ruban protecteur 108. Elle comprend d'ailleurs au moins une phase durant laquelle la gravure est isotrope. La phase de gravure isotrope permet de retirer toutes les parties de l'élément structurel 107 qui ne sont pas protégées, notamment par le ruban protecteur 108. Les tranchées 106 sont ainsi partiellement libérées. La gravure et notamment sa vitesse ainsi que sa durée, sont dimensionnées de manière à ne conserver qu'une portion 109 de l'élément structurel 107 sous chaque ruban protecteur 108, ladite portion 109 formant un pilier. La figure 15 montre le résultat de la gravure partielle par rapport à la figure 11. Dans la figure 11 (qui correspond à une section le long d'une tranchée 106) l'élément structurel 107 occupe toute la tranchée 106. Dans la figure 15, il n'y a que trois piliers 109, placés sous chaque ruban protecteur 108, qui restent dans la tranchée 106. Le reste de la tranchée 106 est libre. La gravure partielle peut comporter qu'une seule phase de gravure et en l'occurrence une phase de gravure isotrope. Toutefois, dans certaines conditions, une gravure isotrope peut retirer trop rapidement les parties de l'élément structurel 107 qui sont masqués par le ruban protecteur 108. Afin de retirer plus rapidement les parties non masquées (par exemple les parties exposées dans la tranchée) pour ne conserver que le pilier 109 sous le ruban 108, la gravure peut comprendre plusieurs phases de gravure. Elle comprend par exemple au moins une phase de gravure anisotrope et au moins une phase de gravure isotrope, par exemple en alternance (par exemple anisotrope/isotrope/anisotrope/...). Une phase de gravure isotrope suit préférentiellement une phase de gravure anisotrope. Les phases de gravure anisotrope sont réalisées avec une directivité sensiblement perpendiculaire au substrat. Ainsi, lors de ces phases, il n'y a que les parties de l'élément structurel 107 qui sont exposées (c'est-à-dire non-masquées par le ruban) qui sont attaquées par la gravure. Lors des phases isotropes, les parties de l'élément structurel 107, même disposées sous le ruban 108, sont gravées. Les parties exposées sont ainsi attaquées pendant les deux phases de gravure tandis que les parties masquées ne sont attaquées que pendant la phase isotrope. La vitesse de gravure des parties exposées est donc augmentée par rapport à la vitesse de gravure des parties masquées.

La phase isotrope de la gravure partielle peut être réalisée en milieu humide par exemple à base d'acide fluorhydrique (HF) avec une concentration en HF comprise entre 0,1% et 2% et à température ambiante. La phase isotrope peut également être réalisée par une gravure sèche isotrope, par exemple à base de SF₆ (pour graver du silicium amorphe) ou à base de HF (pour graver de l'Al₂O₃ sans graver le silicium amorphe).

La gravure partielle laisse un pilier 109 sous chaque ruban 108. Chaque pilier 109 de l'élément structurel 107 est délimité par une surface latérale périphérique, que l'on nommera également « flanc ». Chaque pilier 109 est intégralement délimité par un flanc. Dans l'exemple des figures 4 à 16, le flanc comprend quatre surfaces consécutives, dont :
- deux surfaces opposées l'une à l'autre et perpendiculaires à l'axe Y ; et
- deux autres surfaces 109a, 109b, dites « côtés du pilier », également opposées l'une à l'autre et perpendiculaires à l'axe X' (et X).

Les deux côtés 109a, 109b du pilier sont d'ailleurs perpendiculaire à la tranchée 106, cette dernière s'étendant selon la direction X'. Comme l'élément structurel 107 rempli initialement la tranchée 106 séparant les deux îlots, les surfaces perpendiculaires à Y sont en contact avec les îlots 101. À l'inverse, les côtés du pilier 109a, 109b, perpendiculaires à X' et donc à la tranchée 106, sont libres car en regard des portions de tranchée 106 qui ont été dégagées par la gravure. Par effet de gravure isotrope, les côtés du pilier 109a, 109b peuvent présenter une forme concave, entrant légèrement dans le pilier 109.

Chaque ruban protecteur 108 présente également des bords 108a, 108b, s'étendant perpendiculairement à la direction X', c'est-à-dire perpendiculairement à la tranchée 106 qu'il chevauche. Les côtés 109a, 109b du pilier 109 sont sensiblement perpendiculaire aux bords 108a, 108b du ruban protecteur 108 soutenu par ledit pilier 109.

Puisque la gravure est réalisée de manière sélective par rapport à chaque ruban protecteur 108, les bords du ruban 108a, 108b restent intacts (ou changent très peu). La gravure partielle est réalisée de manière à reculer les côtés 109a, 109b de chaque pilier 109 par rapport aux bords 108a, 108b du ruban protecteur 108. Ainsi, pour chaque ruban 108, les côtés 109a, 109b du pilier 109 supportant ledit ruban 108 sont disposés en retrait des bords 108a, 108b dudit ruban 108. De la sorte, le ruban protecteur 108 présente deux parties 110a, 110b s'étendant en porte-à-faux, au-delà du pilier 109. Les parties 110a, 110b du ruban 108 en porte-à-faux surplombent ainsi la tranchée 106 et plus particulièrement le substrat 102 mis à nu dans la tranchée 106, lors de la gravure.

Par « retrait », on entend une distance latérale, mesurée selon une direction X' et parallèlement au substrat 102, entre l'un des bords 108a, 108b du ruban protecteur 108 et le plus proche côté 109a, 109b du pilier 109Ce retrait correspond à l'avancement de la partie 110a, 110b en porte-à-faux du ruban protecteur 108. Le retrait est préférentiellement supérieur à 100 nm.

La gravure partielle de l'élément structurel 107 a également pour effet de centrer chaque pilier 109 sous le ruban protecteur 108 qu'il supporte. Ainsi, chaque pilier 109 porte de manière effective le ruban protecteur 108. Le retrait de l'élément structurel 107 sous le ruban protecteur 108 permet de former un pont joignant les deux îlots 101 et présentant des parties 110a, 110b en porte-à-faux, surplombants le substrat 102.

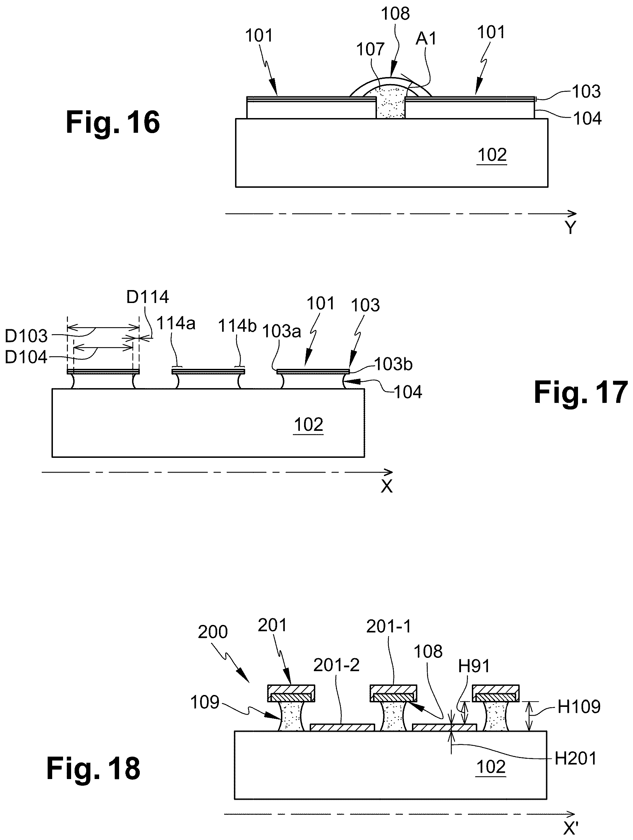

Les figures 18 à 20 montrent l'issue d'une étape de dépôt, par exemple par évaporation, d'une couche organique 201 destinée à former un élément actif du pixel final de l'affichage 200. Le matériau organique déposé est configuré pour générer un rayonnement électromagnétique lorsqu'il est parcouru par un courant électrique. Le rayonnement émis peut être de couleur blanche ou de couleur équivalente rouge, verte ou bleue. La couche organique 201 peut comprendre une seule couche configurée pour émettre un rayonnement ayant spectre situé par exemple principalement dans le bleu, c'est-à-dire un spectre s'étendant dans une gamme de longueurs d'onde comprise entre 430 nm et 490 nm. La couche active 201 peut comprendre alternativement plusieurs sous-couches émissives permettant de former une structure OLED dite « tandem » (non représentée). Dans ce cas, la couche organique 201 comprend plusieurs sous-couches organométalliques comportant, typiquement, deux sous-couches organiques émissives disposées l'une sur l'autre et séparées par des couches fonctionnelles organiques de type transport de charges, injection de charge et/ou génération de charges. Dans la description qui suit, par souci de simplicité, on désignera par « couche organique » une couche homogène, un empilement de sous-couches organiques ou un empilement de sous-couches organométalliques.

La couche organique 201 est préférentiellement déposée de manière anisotrope selon une direction sensiblement perpendiculaire au substrat 102. Par « sensiblement perpendiculaire », on entend perpendiculaire à +/- 20 degrés près. Le dépôt est réalisé pleine plaque. Grâce au retrait du pilier 109 supportant le ruban protecteur, la couche organique 201 se scinde en deux portions 201-1, 201-2 distinctes. Une première portion 201-1 s'étend sur chaque îlot 101 et sur le ruban protecteur 108, faisant office de pont et reliant ces îlots 101. Une deuxième portion 201-2 de la couche organique 201 s'étend sur le substrat 102, dans les tranchées 106 libérées par la gravure partielle de l'élément structurel 107. Puisque les côtés 109a, 109b des piliers 109 sont en retrait, il n'y a pas de matériau organique qui s'accumule contre ces côtés. Les côtés 109a, 109b sont protégés par les parties 110a, 110b en porte-à-faux du ruban protecteur 108. Il n'y a donc pas de dépôt de matière organique qui puisse former une liaison entre les deux portions 201-1, 201-2 de la couche organique 201. Les parties 110a, 110b en porte-à-faux du ruban protecteur 108, surplombant le substrat 102, font tomber l'excédent de matériau organique au centre des tranchées 106 et à distance des côtés 109a, 109b du pilier 109.

La couche organique 201 peut déborder légèrement sur les parties 110a, 110b du ruban protecteur 108 en porte-à-faux, formant un chapeau qui recouvre la partie supérieure du ruban 108 ainsi que les bords 108a, 108b du ruban 108.

Afin de garantir une séparation des portions 201-1, 201-2 de la couche organique 201, l'épaisseur H201 de la couche organique 201 est préférentiellement inférieure à la hauteur H109 du pilier 109. De la sorte, la deuxième portion 201-2 de la couche organique 201, s'étendant sur le substrat 102, n'atteint pas le ruban protecteur 108 et notamment ses parties 110a, 110b, en porte-à-faux au-dessus de la deuxième portion 201-2. En effet, si l'épaisseur atteint la hauteur H109 du pilier 109, la couche organique 201 atteint alors le bord du ruban protecteur 108. Puisque le matériau organique peut recouvrir les bords du ruban 108, il y a une forte chance qu'une continuité entre les deux portions 201-1, 201-2 puisse s'établir. Pour garantir une marge suffisante, la hauteur H109 du pilier 109 est préférentiellement supérieure à 1,2 fois l'épaisseur de dépôt H201 de la couche organique 201 et de manière encore préférée supérieure à 1,4 fois, voire supérieure à 2 fois, l'épaisseur de dépôt H201 de la couche organique 201. L'épaisseur de dépôt H201 est considérée égale pour les deux portions 201-1, 201-2 de la couche organique 201 car ces deux portions 201-1, 201-2 sont déposés lors de la même étape. La mesure de l'épaisseur de dépôt H201 est préférentiellement mesurée à un endroit où cette épaisseur varie peu, par exemple loin des bords. La couche organique 201 présente préférentiellement une épaisseur de dépôt H201 comprise entre 100 nm et 200 nm.

Les étapes décrites précédemment permettent ainsi de former un dispositif 200 d'affichage électroluminescent. Dans l'exemple des figures 18 à 20, le dispositif 200 comprend des colonnes de pixels, chaque colonne de pixels étant formée à partir d'une colonne d'îlots 101. Les pixels sont disposés sur le substrat 102 et comprennent chacun une couche support 104, une électrode inférieure 103 et une couche organique 201, s'étendant de manière continue sur toute la colonne de pixels. En particulier, en considérant seulement deux des pixels d'une même colonne de pixels, le dispositif 200 comprend une tranchée 106 séparant les deux pixels et un pilier 109 disposé dans cette tranchée 106 et isolant électriquement les deux électrodes inférieures 103 des pixels. Une couche organique 201 s'étend sur chaque électrode inférieur 103. Un ruban protecteur 108, formant un pont joignant les électrodes inférieures 103 des deux îlots 101, et supporté par le pilier 109, offrant ainsi un support à la couche organique 201 qui s'étend ainsi de tout son long, sur les électrodes inférieures 103 de chaque pixel.

Les différentes colonnes de pixels du dispositif 200 sont séparées les unes des autres par des tranchées 106. Les parties 110a, 110b du ruban 108 en porte-à-faux permettent de scinder la couche organique en deux portions 201-1, 201-2 distinctes de sorte que la portion 201-2 s'étendant dans la tranchée 106 soit électriquement isolée de la portion 201-1 s'étendant sur les îlots 101.

Afin de parfaire le dispositif 200, une étape complémentaire de dépôt d'une couche conductrice supplémentaire 204 peut être réalisée. Cette couche conductrice supplémentaire 204 peut former une électrode supérieure pour les pixels finaux. Cette électrode supérieure est préférentiellement transparente ou semi-transparente, que l'électrode inférieure 103 soit opaque ou réfléchissante. Par « semi-transparent », on entend un élément qui, présente, pour au moins une longueur d'onde de la bande spectrale [400 nm ; 1000 nm], voire [400 nm ; 2000 nm], un coefficient de transmission optique pouvant être compris entre 40% et 60%.

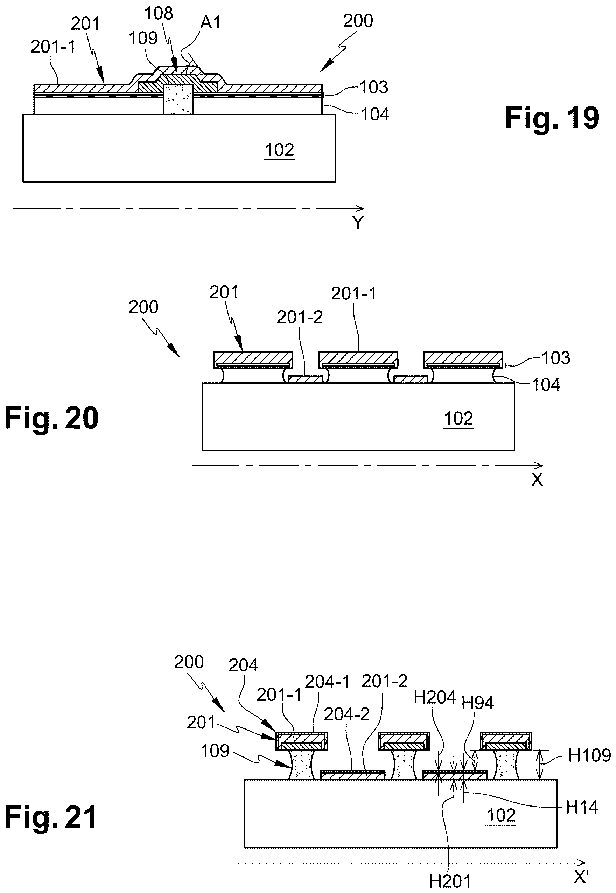

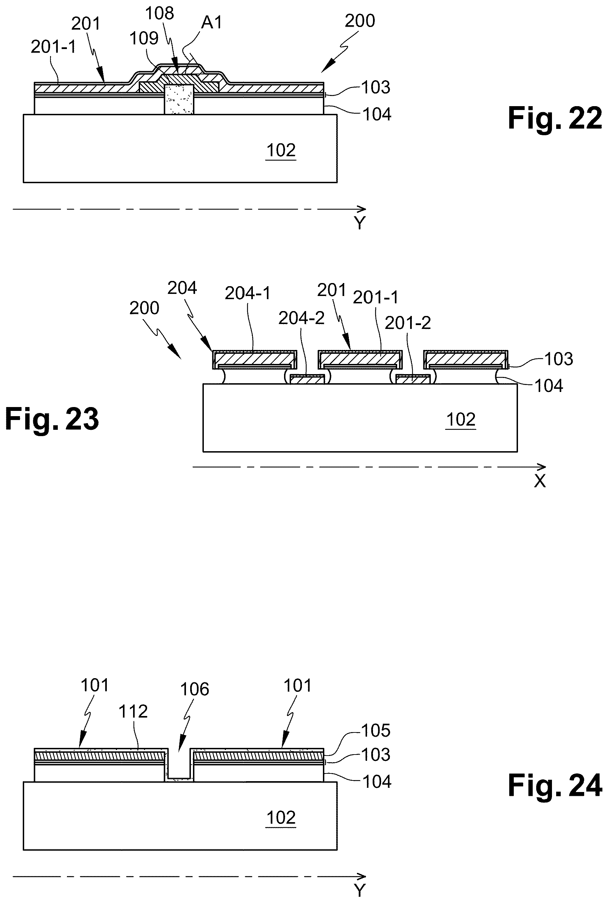

Les figures 21 et 23 montrent l'issue de cette étape complémentaire. La couche conductrice supplémentaire 204 est réalisée de manière à présenter au moins une portion 204-1 recouvrant totalement la première portion 201-1 de la couche organique 201. Ainsi, cette portion 204-1 de la couche conductrice supplémentaire 204 forme une électrode supérieure du dispositif 200 et notamment une électrode supérieure commune à la colonne d'îlots 101. Ainsi l'application d'un potentiel électrique entre l'électrode supérieure 204-1 et l'une des électrode inférieure 103 permet d'appliquer un champ électrique sur une partie de la couche organique disposée entre ces deux électrodes 204-1, 103. La couche conductrice supplémentaire 204 est par exemple formée à partir d'un oxyde transparent conducteur (ou TCO, pour « Transparent Conductive Oxyde » en anglais) ou d'un film d'Argent fin semi-transparent ou d'un film d'Aluminium fin semi-transparent.

Le dépôt de la couche conductrice supplémentaire 204 est préférentiellement réalisé de manière anisotrope avec une direction sensiblement perpendiculaire au substrat 102. De manière similaire à la couche organique 201, la couche conductrice supplémentaire 204 se scinde en deux portions 204-1, 204-2 distinctes et séparées l'une de l'autre. Une première portion 204-1 s'étend de manière continue sur la première portion 202 de la couche organique 201 et forme l'électrode supérieure. Une deuxième portion 204-2 de la couche conductrice supplémentaire 204 s'étend dans la tranchée 106 séparant les colonnes d'îlots 101, et sur la deuxième portion 203 de la couche organique 201.

Afin de garantir une isolation électrique entre ces deux portions 204-1, 204-2, le dépôt de la couche conductrice supplémentaire 204 est réalisé avec une épaisseur de dépôt H204 telle que la couche conductrice supplémentaire 204 n'atteigne pas le ruban protecteur 108 et en particulier les parties 110 du ruban 108 en porte-à-faux. Par exemple, la somme de l'épaisseur de dépôt H201 de la couche organique 201 et de l'épaisseur de dépôt H204 de la couche conductrice supplémentaire 204 est strictement inférieure à la hauteur H109 du pilier 109 supportant le ruban protecteur 108. Pour garantir une marge suffisante, la hauteur H109 du pilier 109 est préférentiellement supérieure à 1,2 fois la somme de l'épaisseur H201 de la couche organique 201 et de l'épaisseur H204 de la couche conductrice supplémentaire 204, et de manière encore préférée supérieure à 1,5 fois, voire supérieure à 2 fois, la somme de ces épaisseurs H201, H204. Autrement dit H109 > 1,2×(H201 + H204), et de manière préférée H109 > 1,5×(H201 + H204).

En complément, la finalisation du dispositif 200 peut comprendre un dépôt d'une ou plusieurs couches d'encapsulation permettant de protéger les matériaux oxydables. Il s'agit par exemple de protéger les couches formées en oxyde d'aluminium, en silice ou encore en nitrure. La couche d'encapsulation ou les couches d'encapsulation sont par exemple formées par dépôt atomique monocouche (dit « ALD » pour « Atomic Layer Deposition » en anglais) ou par dépôt chimique en phase vapeur (dit « CVD » pour « Chemical Vapor Deposition »).

Les figures 12 et 13 montrent deux exemples de ruban protecteur 108 pouvant être obtenus à l'issu de l'étape de formation dudit ruban 108. Les figures 12 et 13 présentent une section réalisée le long d'une colonne d'îlots 101 montrant ainsi le profil du ruban 108 pour chaque exemple.

Dans le cas de la figure 12, l'élément structurel 107 sous-jacent au ruban 108 présente une section rectangulaire. L'élément structurel 107 comprend notamment deux flancs 107a, 107b, chacun d'eux étant en contact avec un des deux îlots 101 à séparer. Ces flancs 107a, 107b s'étendent perpendiculairement au substrat 102 jusqu'à dépasser les sommets des îlots 101. La portion de l'élément structurel 107 dépassant des îlots 101 présente ainsi une forme de marche avec des arêtes franches. Ces arêtes ne permettent pas la formation de la couche organique 201. En effet, le dépôt de matériau organique sur des arêtes franches tend à rompre la couche résultante. Elle ne forme donc plus une couche continue s'étendant d'un îlot 101 à l'autre. Pour réduire ce risque, la couche organique peut être formée très épaisse pour gommer la présence des arêtes franches et des brisures ou des cassures. Tout toutefois, une couche organique trop épaisse tend à réduire l'efficacité du dispositif 200 résultant.

Le ruban protecteur 108 permet de recouvrir l'élément structurel 107 en gommant, au moins en partie, les arêtes franches de ce dernier. Le ruban protecteur 108 est par exemple réalisé par lithographie, faisant notamment intervenir une étape de dépôt d'un matériau. Ce dépôt recouvre les arrêtes franches et forme un pont chevauchant l'élément structurel 107, la surface libre de ce pont est suffisamment « douce » pour que la couche organique 201 puisse s'étendre de manière continue, sans brisure ni coupure. Par « douce », on entend que la surface libre présente une tangente par rapport au substrat (également appelé « pente » et matérialisée par le signe A1 dans la figure 12) comprise en -45° et 45° et préférentiellement comprise entre -20° et 20° et de manière encore préférée comprise entre -5° et 5°.

La figure 13 présente un mode de réalisation dans lequel l'élément structurel 107 est modifié de manière à ne plus présenter d'arêtes franches. Ainsi, le ruban 108, s'étendant directement contre l'élément structurel 107, présente une surface libre s'étendant continument d'un îlot 101 à l'autre, sans arrête et ni discontinuité. Ce mode de réalisation est le plus susceptible d'offrir un pont entre les deux îlots permettant de former une couche organique sans défaut. Pour obtenir ce ruban 108, l'élément structurel 107 subit un fluage ou un gonflement visant à faire déborder la portion de l'élément 107 dépassant des îlots sur le bord de ces îlots 101. Cette étape de fluage ou de gonflement adoucit ainsi, voire gomme, les arêtes franches. L'élément structurel 107 présente ainsi une pente douce permettant de former un ruban protecteur 108 également en pente douce. Le fluage ou le gonflement peuvent être réalisés par un traitement thermique de l'élément structurel 107. L'élément structurel 107 est par exemple traité thermiquement à 200°C pendant 30 minutes suivie d'un séchage de manière à fixer irréversiblement la déformation. Le ruban 108 peut être formé dans un second temps, par exemple par lithographie.

Les figures 1 à 3 présentent une variante du précurseur 100 à partir duquel est formé le dispositif 200 d'affichage. Dans cette variante, chaque îlot 101 comprend une couche sacrificielle 105 s'étendant sur l'électrode inférieure 103. Elle est par exemple formée à partir d'un matériau diélectrique tel que l'oxyde de silicium SiO₂, l'oxyde d'aluminium Al₂O₃ et préférentiellement le nitrure de silicium SiN. Le nitrure de silicium SiN forme une couche d'arrêt efficace pour réaliser une étape de polissage.

En présence des couches sacrificielles 105, le remplissage de la tranchée 106 avec l'élément structurel 107 (tel qu'illustré par les figures 4 à 6) est réalisé de sorte que l'élément structurel 107 atteigne le sommet des couches sacrificielles 105. Par exemple, le matériau destiné à former l'élément structurel 107 est déposé pleine plaque en remplissant les tranchées 106 et en recouvrant les îlots 101. Une planarisation chemique et physique (dite « CMP » pour « Chemical and Physical Planarisation » en anglais) avec arrêt sur les couches sacrificielles 105 permet de dégager le sommet des îlots 101. Enfin, une gravure de la couche sacrificielle 105, consécutive à la CMP permet de dégager les électrodes inférieures 103. Cette gravure des couches sacrificielles 105 est préférentiellement réalisée de manière sélective par rapport à l'élément structurel 107 et avec arrêt au niveau des couches conductrices 103. Cette gravure conserve toutefois une portion de l'élément structurel 107, dépassant les îlots 101 et en particulier les couches conductrices 103.

L'épaisseur des couches sacrificielles permet de fixer la hauteur H73 de l'élément structurel 107 dépassant les couches conductrices inférieure 103. Pour chaque îlot, la couche sacrificielle 105 présente par exemple une épaisseur comprise entre 10 nm et 100 nm, afin d'assurer correctement le rôle de couche d'arrêt pour une étape de CMP. Ainsi, la hauteur H73 peut être comprise entre 10 nm et 100 nm.

Il est bien entendu avantageux que l'élément structurel 107 ne dépasse pas des électrodes inférieures 103. Ainsi, il n'y a pas d'arrêtes à gommer et la réalisation du ruban 108 est simplifiée. Le dépassement des électrodes inférieures 103 par l'élément structurel 107 est une conséquence de la gravure des couches sacrificielles 105.

Il est toutefois envisageable de graver les couches sacrificielles 105 de manière non sélective par rapport à l'élément structurel 107. Dès lors, une partie plus ou moins grande de l'élément structurel 107 est retiré en même temps que les couches sacrificielles 105. Lorsque la vitesse de gravure de l'élément structurel 107 est égale à la vitesse de gravure des couches sacrificielles 105, par exemple à 10 % près, la marche de l'élément structurel 107 (la partie dépassant des couches conductrices 103) est retirée en même temps que les couches sacrificielles 105. Une marche de hauteur réduite peut subsister. Toutefois si elle présente une hauteur H73 inférieure à 30 nm, elle n'a pas d'effet sur la formation de la couche organique 201.

Dans une variante, la couche conductrice 103 est suffisamment dure pour jouer le rôle de couche d'arrêt pour une CMP. Dès lors, la couche sacrificielle 105 n'est pas utile et l'élément structurel 107 atteint les couches conductrices 103 sans les dépasser. Les couches sacrificielles 105 peuvent également être suffisamment conductrices pour ne pas avoir besoin d'être retirées. Elles peuvent donc intégrée dans les pixels finaux, comme si elles faisaient partie des couches conductrices 103.

Dans les figures 4 à 9, l'élément structurel 107 est réalisé à partir d'un matériau électriquement isolant. Il s'agit par exemple d'oxyde de silicium SiO2, nitrure de silicium SiN, oxyde d'aluminium Al2O3. Alternativement, l'élément structurel 107 peut être un matériau à base de polymère tel qu'une résine (notamment en vue de réaliser une étape de fluage ou de gonflement de l'élément structurel 107). L'élément structurel 107 est même préférentiellement uniquement composé d'un matériau électriquement isolant tels que ceux précités.

Le remplissage est par exemple réalisé par dépôt du matériau isolant de manière à remplir complètement la tranchée 106. Le remplissage est par exemple réalisé par dépôt pleine plaque du matériau électriquement isolant (ou du polymère) suivi d'un polissage (également appelé « planarisation ») avec arrêt au niveau des couches sacrificielles 105 (préférentiellement en SiN). Avant de former le ruban protecteur 108 et dans l'hypothèse où les couches sacrificielles 105 sont isolantes, lesdites couches sacrificielles 105 sont préférentiellement retirées suivant le mode opératoire décrit précédemment.

Les figures 24 à 27 présentent une variante du procédé de fabrication et notamment de l'élément structurel 107. Ce dernier n'est pas réalisé par un matériau homogène et électriquement isolant. Il comprend deux matériaux : un premier matériau, diélectrique, permettant d'isoler électriquement les îlots entre eux ; et un deuxième matériau, dit de « remplissage » pouvant être isolant ou non, et donc le rôle est de remplir la tranchée 106 pour offrir un support au ruban protecteur 108. Le premier matériau diélectrique s'étend par exemple contre chacun des îlots séparés par l'élément structurel.

La figure 24 montre par exemple une passivation du précurseur 100 des figures 1 à 3. La couche de passivation 112 s'étend, de manière continue, sur les îlots 101 et dans la tranchée 106 séparant ces îlots 101. La couche de passivation 112 recouvre notamment les couches sacrificielles 105 s'étendant sur les électrodes inférieures 103.

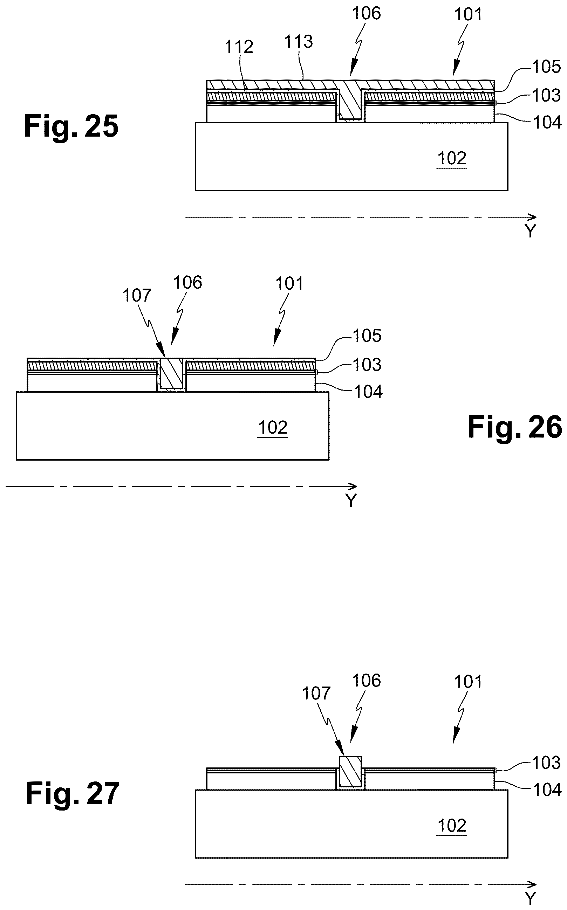

La figure 25 montre un remplissage de la tranchée 106 passivée. Le matériau de remplissage 113 est déposé pleine plaque de manière à remplir complètement la tranchée 106 et la dépasser.

La figure 26 montre un polissage de l'empilement de la figure 25 avec arrêt sur les couches sacrificielles 105. Le matériau de remplissage 113 et la couche de passivation 112 à l'extérieur de la tranchée 106 sont ainsi retirés. L'élément structurel 107 résultant comprend alors : une couche diélectrique, correspondant à la couche de passivation 112 et tapissant le fond et les flancs de la tranchée 106 ; et un matériau de remplissage 113 remplissant le reste de la tranchée 106.

À la différence de l'élément structurel 107 des figures 4 à 6, l'élément structurel 107 n'est pas forcément entièrement isolant électriquement. En effet, la couche de passivation 112 suffit à réaliser l'isolation électrique entre les îlots 101. Le matériau de remplissage 113 n'est donc pas forcément isolant. Il peut d'ailleurs être conducteur électrique. Il est par exemple en silicium amorphe ou silicium polycristallin.

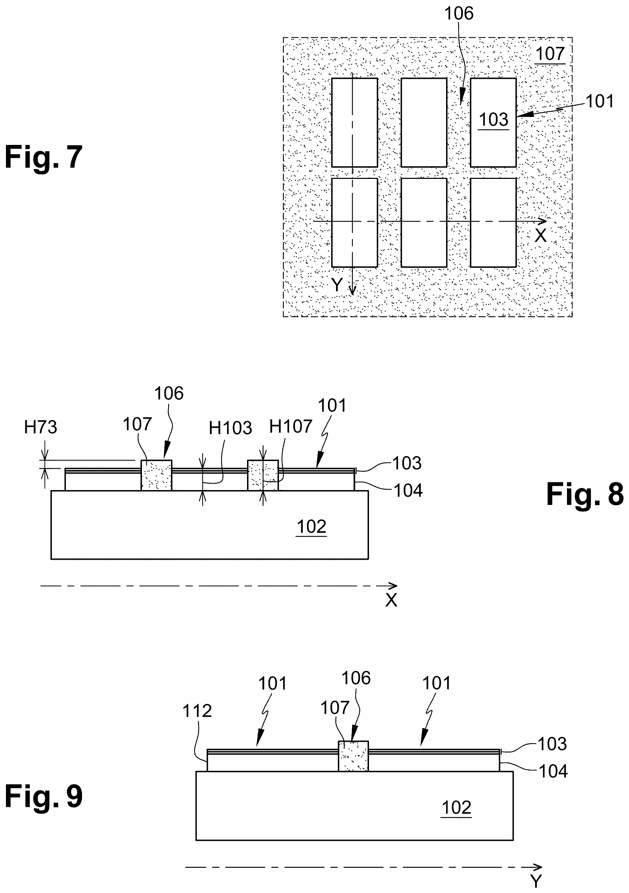

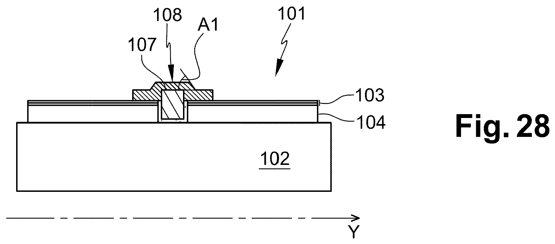

L'étape de retrait des couches sacrificielles 105 est réalisée sélectivement par rapport à l'élément structurel 107 des figures 7 à 9. Cela peut également être le cas avec l'élément structurel 107 de la figure 26. Toutefois, dans une variante illustrée par la figure 27, le retrait des couches sacrificielles 105 peut être réalisée sélectivement par rapport au matériau de remplissage 113 de l'élément structurel 107. Ainsi, la couche de passivation 112 peut être retirée pour ne laisser dépasser que le matériau de remplissage 113. La figure 28 montre un exemple de ruban protecteur 108 recouvrant l'élément structurel 107 et en particulier le matériau de remplissage 113 de cet élément 107. Dans l'éventualité où le matériau de remplissage 113 est conducteur électrique, alors le ruban protecteur 108 est nécessairement électriquement isolant.

La figure 17 présente une variante de réalisation de la gravure partielle de l'élément structurel 107. En effet, la gravure de l'élément structurel 107 peut être réalisé de manière isotrope et sélective par rapport au ruban protecteur 108 et aux électrodes inférieures 103. Ainsi, les électrodes inférieures 103 restent intactes tandis que les parties exposées des couches support 104 (c'est-à-dire susceptibles d'être exposées à une gravure isotrope) peuvent également être partiellement gravées. À l'issue de cette gravure, chaque couche support 104 montre alors un retrait D114 par rapport aux bords 103a, 103b des électrodes inférieures. Chaque électrode inférieure 103 présente alors des parties 114a, 114b, en porte-à-faux. Ces porte-à-faux surplombent le substrat 102.

Les figures 20 et 23 présentent l'issue des étapes de dépôt de la couche organique 201 et de la couche conductrice supplémentaire 204. Suivant le même principe qu'au niveau des rubans protecteurs 108, les parties 114a, 114b en porte-à-faux permet de former les couches organique 201 et conductrice 204 en scindant ces couches en deux portions distinctes. Ainsi, ces couches 201, 204 peuvent être déposées sur plusieurs colonnes d'îlots 101 en même temps sans qu'il y ait de contact électrique entre les colonnes. En revanche, les couches 201, 204 peuvent s'étendre de manière continue sur chaque colonne d'îlots 101. Les épaisseurs de dépôt de dépôt H201, H204 des couches 201, 204 sont contraintes de sorte que, lorsqu'elles forment un empilement dans une tranchée 106, elles ne puissent pas atteindre les électrodes inférieures 103 et en particulier les parties 114 en porte-à-faux. Ainsi, la somme des épaisseurs de dépôt H201, H204 est préférentiellement strictement inférieure à la hauteur des couches de support 104 (cette dernière étant normalement inférieure à la hauteur des piliers 109).

Le dispositif d'affichage 200 résultant du procédé détaillé ci-dessus comprend ainsi plusieurs pixels comprenant chacun une électrode inférieure 103 et une couche organique 201 s'étendant sur chaque électrode inférieure 103. Le dispositif 200 est particulier en ce que la couche organique 201 s'étend de manière continue, d'un seul tenant, sur la pluralité de pixels. Ceci est rendu possible grâce à un ou plusieurs rubans protecteur 108 permettant de former un pont entre les pixels. La pluralité de pixels peut également présenter, à un stade plus avancé, une électrode supérieure 204, commune à tous les pixels, s'étendant, comme la couche organique 201, de manière continue et d'un seul tenant sur la pluralité de pixels.

Le ou les rubans protecteurs 108, voire les électrodes inférieurs 103, présentent des parties périphériques en porte-à-faux, permettant de minimiser le risque de défaut de fabrication tout en relâchant l'une des contraintes de fabrication qu'est l'angle de dépôt du matériau organique 201 et de l'électrode supérieure 204.

Dans les différents modes de réalisation présentés, les îlots 101 présentent des électrodes inférieures 103 distinctes. Certains îlots pourraient toutefois présenter des électrodes inférieures 103 communes. Par exemple, dans la figure 1, les îlots 101 peuvent être regroupés par groupe de couleur. Des îlots 101 d'une même couleur sont par exemple alignés par colonne, c'est-à-dire selon la direction Y. En l'occurrence la figure 1 montre trois colonnes de pixels pouvant correspondre à trois couleurs distinctes. À l'issu du procédé, l'électrode supérieure 204 peut être commune à plusieurs îlots 101, par exemple les îlots d'une même colonne. L'électrode supérieure 204 s'étend par exemple de manière continue selon la direction Y. Cet arrangement de pixels est nommé « arrangement en bandes » ou en « strip » en anglais.

Dans un développement, l'électrode inférieure 103 peut être formée de manière à s'étendre sur plusieurs îlots 101. Toutefois, afin de pouvoir adresser distinctement chaque pixel, il est avantageux que l'électrode inférieure 103 commune ne connecte pas les mêmes îlots que l'électrode supérieure 204 commune. Par exemple, l'électrodes inférieure 103 peut connecter des pixels faisant parties de différentes colonnes. Par exemple, dans la figure 1, les îlots pourraient être connectés par deux électrodes inférieures 103 s'étendant perpendiculairement aux colonnes, c'est-à-dire selon X. L'une des électrodes inférieures 103 connecte par exemple les trois îlots 101 du haut tandis que l'autre électrode inférieur 103 connecte les trois îlots 101 du bas. Ainsi, les électrodes communes inférieures et supérieures 103, 204 forment un réseau d'électrodes s'entrecroisant, généralement nommé « cross-bar » en anglais, permettant d'adresser les pixels un à un.

Un dispositif 200 issu du procédé selon l'invention peut avantageusement être intégré dans un système d'affichage, tel qu'un écran d'appareil électronique, comprenant une matrice d'adressage. La matrice d'adressage est par exemple disposée en partie dans le substrat 102. Elle est alors configurée pour adresser chaque électrode inférieure 103 des pixels. Elle comprend par exemple des électrodes s'étendant dans le substrat et débouchant à la surface du substrat 102, couche chaque couche support 104. La couche de support 104, étant conductrice ou comprenant au moins une portion conductrice (telle que la portion 116 des figures 2 et 3), permet la connexion entre les électrodes inférieures 103 et la matrice d'adressage.

La matrice d'adressage peut être une matrice dite « passive ». Elle comprend par exemple une pluralité de lignes conductrices s'entrecroisant, chaque pixel étant connecté à l'intersection entre deux lignes conductrices. Toutefois, dans un développement avantageux, les lignes conductrices s'entrecroisant peuvent être formées par :
- les électrodes supérieures 204, s'étendant par exemple selon une direction (par exemple Y) et communes à plusieurs pixels ; et
- les électrodes inférieures 103, s'étendant perpendiculairement aux électrodes supérieures 204 (par exemple selon X) et communes à plusieurs pixels.

La matrice d'adressage peut être une matrice dite « active ». Elle permet de former un système d'affichage de type AMOLED pour « Active Matrix Organic Light-Emitting Diode » en anglais. La matrice active permet de contrôler chaque pixel de manière indépendante. Elle comprend une pluralité de transistors à couche mince (dit « TFT » pour « Thin-Film Transistor » en anglais). Chaque TFT est connecté à une électrode inférieure 103 de pixel de manière à contrôler chaque pixel indépendamment. Dans un mode de réalisation, les électrodes supérieures 204 sont connectées à une cathode commune, par exemple en bord de matrice.

## Revendications

1. Procédé (300) de fabrication d'un dispositif (200) d'affichage électroluminescent à partir d'un précurseur (100), ledit précurseur (100) comprenant une pluralité d'îlots (101), disposés sur un substrat (102), chaque îlot (101) comprenant une couche support (104) s'étendant sur le substrat (102) ; et une couche conductrice (103) s'étendant sur la couche support (104), les îlots étant séparés deux à deux par une tranchée (106), le procédé (300) comprenant :
- un remplissage de chaque tranchée (106) séparant les îlots (101) avec un élément structurel (107) isolant électriquement les îlots (101), pour chaque tranchée (106), le remplissage étant réalisé jusqu'à ce que ledit élément structurel (107) atteigne le sommet des îlots (101) séparés par ladite tranchée (106) ;
- une formation d'au moins un ruban protecteur (108), chaque ruban protecteur (108) connectant deux îlots (101) entre eux en chevauchant la tranchée (102) séparant lesdits deux îlots (101) et en recouvrant l'élément structurel (107) s'étendant dans la tranchée (106), chaque ruban protecteur (108) recouvrant, en partie seulement, chacun des deux îlots (101) qu'il connecte ;
- une gravure partielle de l'élément structurel (107) de manière sélective par rapport à chaque ruban protecteur (108) et par rapport aux couches conductrices (103) des îlots (101), la gravure partielle comprenant au moins une phase de gravure isotrope, la gravure partielle étant réalisée de manière à ne conserver qu'une portion (109) de l'élément structurel (107) disposée sous chaque ruban protecteur (108) et ladite portion (109) formant un pilier pour chaque ruban protecteur (108), la gravure partielle étant en outre réalisée de sorte qu'au moins une partie (110a, 110b) de chaque ruban protecteur (108) s'étendant en porte-à-faux au-delà du pilier (109) qui le supporte ; et
- un dépôt d'une couche organique (201) de manière anisotrope avec un angle sensiblement perpendiculaire au substrat (102) d'où il résulte deux portions (201-1, 201-2) distinctes et séparées de la couche organique (201) dont, une première portion (201-1) s'étendant de manière continue sur chaque îlot (101) et sur chaque ruban protecteur (108), et une deuxième portion (201-2) s'étendant sur le substrat (102), une épaisseur de dépôt de la couche organique (201) étant choisi de sorte que la deuxième portion (203) de la couche organique (201) n'atteigne pas ladite au moins une partie (110a, 110b) en porte-à-faux de chaque ruban protecteur (108).

2. Procédé (300) selon la revendication 1, dans lequel la gravure partielle de l'élément structurel (107) est réalisée de sorte que l'écart latéral (D110) de ladite au moins une partie en porte-à-faux (110a, 110b) de chaque ruban protecteur (108) par rapport au pilier (109) qui le supporte est strictement supérieure à 100 nm.

3. Procédé (300) selon l'une des revendications 1 ou 2, dans lequel pour chaque tranchée (106), le remplissage est réalisé jusqu'à que l'élément structurel (107) dépasse les couches conductrices (103) des deux îlots (101) séparés par ladite tranchée (106) d'une hauteur comprise entre 10 nm et 100 nm.

4. Procédé (300) selon la revendication 3, dans lequel chaque îlot (101) comprend, avant le remplissage de chaque tranchée (106), une couche sacrificielle (105) s'étendant sur la couche conductrice (103), le remplissage de chaque tranchée (106) avec l'élément structurel (107) étant réalisé de sorte que l'élément structurel (107) atteigne le sommet des couches sacrificielles (105) s'étendant sur les îlots (101).

5. Procédé (300) selon la revendication 4, comprenant en outre, après le remplissage de chaque tranchée (106) et avant la formation de chaque ruban protecteur (108), une gravure de la couche sacrificielle (105) de chaque îlot (101) de manière sélective par rapport à l'élément structurel (107), la gravure étant réalisée avec arrêt sur ladite couche conductrice (103) dudit ilot (101).

6. Procédé (300) selon l'une des revendications 4 ou 5, dans lequel, pour chaque tranchée (106), le remplissage avec l'élément structurel (107) comprend :
- un dépôt d'une couche en matériau électriquement isolant de manière à remplir complètement ladite tranchée (106) ;
- un polissage de la couche en matériau électriquement isolant avec un arrêt sur la couche sacrificielle (105) de chaque îlot (101).

7. Procédé (300) selon l'une des revendications 4 ou 5, dans lequel, pour chaque tranchée (106), le remplissage avec l'élément structurel (107) comprend les étapes suivantes :
- un dépôt d'une couche diélectrique de manière conforme dans ladite tranchée (106) ;
- un dépôt d'une couche en matériau de remplissage sur la couche diélectrique de manière à remplir complètement ladite tranchée (106) ;
- un polissage de la couche diélectrique et la couche de remplissage
avec un arrêt sur la couche sacrificielle (105) de chaque îlot (101).

8. Procédé (300) selon la revendication 7, dans lequel le matériau de remplissage est du silicium amorphe ou du silicium polycristallin.

9. Procédé (300) selon l'une des revendications 1 à 8, comprenant, avant la formation de chaque ruban protecteur (108), un fluage ou un gonflement de l'élément structurel (107) de sorte qu'il déborde sur une portion de la couche conductrice de chaque îlot (101) en formant au moins une surface libre continue et sans arête, s'étendant de la couche conductrice (103) d'un des îlots (101) à la couche conductrice d'un autre îlot (101), chaque surface libre présentant une pente, mesurée par rapport au substrat (102), comprise entre -45 degrés et 45 degrés et préférentiellement entre -20 degrés et +20 degrés.

10. Procédé (300) selon l'une des revendications 1 à 9, dans lequel chaque ruban protecteur (108) est électriquement isolant.

11. Procédé (300) selon l'une des revendications 1 à 10, dans lequel la gravure partielle de l'élément structurel (107) comprend au moins une phase de gravure anisotrope et au moins une phase de gravure isotrope, par exemple en alternance, chaque phase de gravure anisotrope étant réalisée avec une directivité sensiblement perpendiculaire au substrat (102).

12. Procédé (300) selon l'une des revendications 1 à 11, comprenant, après le dépôt de la couche organique (201), un dépôt d'une couche conductrice supplémentaire (204) de manière anisotrope d'où il résulte deux portions (204-1, 204-2) distinctes et séparées de la couche conductrice supplémentaire (204) dont, une première portion (204-1) de la couche conductrice supplémentaire (204) s'étendant de manière continue sur la première portion (201-1) de la couche en matériau organique (201), et une deuxième portion (204-2) de la couche conductrice supplémentaire (204) s'étendant sur la deuxième portion (2021-2) de la couche organique (201), une épaisseur de dépôt de la couche conductrice supplémentaire (204) étant choisi de sorte que la deuxième portion (204-2) de la couche conductrice supplémentaire (204) n'atteigne pas ladite au moins une partie en porte-à-faux (110a, 110b) de chaque ruban protecteur (108).

13. Procédé (300) selon l'une des revendications 1 à 12, dans lequel la gravure partielle de l'élément structurel (107) est en outre réalisée de manière à graver partiellement la couche support (104) de chaque îlot (101) de sorte que, pour chaque îlot (101), au moins une partie (114) de la couche conductrice (103) dudit îlot (101) s'étende en porte-à-faux au-delà de la couche support (104) dudit îlot (101).

14. Dispositif (200) d'affichage électroluminescent comprenant une pluralité d'îlots (101), disposés sur un substrat (102), chaque îlot comprenant une couche support (104) s'étendant sur le substrat (102) et une couche conductrice (103) s'étendant sur la couche support (104), le dispositif comprenant :
- au moins une tranchée (106) séparant les îlots (101) deux à deux ;
- au moins un ruban protecteur (108), chaque ruban protecteur (108) connectant deux îlots (101) entre eux en chevauchant la tranchée (102) séparant lesdits deux îlots (101), chaque ruban protecteur (108) recouvrant, en partie seulement, chacun des deux îlots (101) ;
- au moins un pilier (109) remplissant au moins en partie une tranchée et isolant électriquement les îlots (101) séparés par ladite tranchée (106), chaque pilier (109) atteignant ou dépassant le sommet des deux îlots (101) séparés par ladite tranchée (106), chaque pilier étant disposé sous un ruban protecteur (108) pour supporter ledit ruban protecteur (108) de sorte qu'au moins une partie (110a, 110b) dudit ruban protecteur (108) s'étendant en porte-à-faux au-delà dudit pilier (109) ; et
- une couche organique (201) présentant deux portions (201-1, 201-2) distinctes et séparées l'une de l'autre dont, une première portion (201-1) s'étendant de manière continue sur chaque îlot (101) et sur chaque ruban protecteur (108), et une deuxième portion (201-2) s'étendant sur le substrat (102) sans atteindre ladite au moins une partie en porte-à-faux (110a, 110b) de chaque ruban protecteur (108).

15. Dispositif (200) d'affichage selon la revendication 14, dans lequel l'écart latéral (D110) de ladite au moins une partie en porte-à-faux (110a, 110b) de chaque ruban protecteur (108) par rapport au pilier (109) qui le supporte est strictement supérieure à 100 nm.

16. Dispositif (200) d'affichage selon l'une des revendications 14 ou 15, dans lequel ledit moins un pilier (109) est réalisé à partir d'un matériau électriquement isolant.

17. Dispositif (200) d'affichage selon l'une des revendications 14 à 16, dans lequel ledit au moins un pilier (109) comprend une couche diélectrique, permettant d'isoler électriquement les îlots (101) séparés par ledit au moins un pilier (109) ; et un matériau de remplissage, servant de support au ruban protecteur (108), la couche diélectrique dudit au moins un pilier séparant le matériau de remplissage dudit au moins un pilier de chaque îlot (101).

18. Dispositif (200) d'affichage selon l'une des revendications 14 à 16, dans lequel ledit au moins un pilier (109) présente une surface continue et sans arête sur laquelle s'étend le ruban protecteur (108), ladite surface continue et sans arrête s'étendant de la couche conductrice (103) d'un des îlots (101) à la couche conductrice d'un autre îlot (101), chaque surface continue et sans arrête présentant une pente, mesurée par rapport au substrat (102), comprise entre -45 degrés et 45 degrés et préférentiellement entre -20 degrés et +20 degrés.

19. Système d'affichage électroluminescent, comprenant :
- un dispositif (200) selon l'une des revendications 14 à 18 ; et
- une matrice d'adressage active comprenant une pluralité de transistors, chaque transistor de la pluralité de transistors étant connecté à la couche conductrice (103) d'un des îlots (101) dudit dispositif (200).
